## Europäisches Patentamt
## European Patent Office
## Office européen des brevets

(11) Publication number: **0 069 762**
**B1**

(12) EUROPEAN PATENT SPECIFICATION

(45) Date of publication of patent specification: **08.02.89**

(51) Int. Cl.⁴: **H 05 K 1/18**

(21) Application number: **82900481.1**

(22) Date of filing: **22.12.81**

(86) International application number:
**PCT/US81/01725**

(87) International publication number:
**WO 82/02640 05.08.82 Gazette 82/19**

(54) UNIVERSAL INTERCONNECTION SUBSTRATE.

(30) Priority: **16.01.81 US 225581**

(43) Date of publication of application:
**19.01.83 Bulletin 83/03**

(45) Publication of the grant of the patent:
**08.02.89 Bulletin 89/06**

(84) Designated Contracting States:
**BE CH DE FR GB LI NL SE**

(56) References cited:
**US-A-3 312 871**
**US-A-3 377 513**
**US-A-3 500 148**
**US-A-3 679 941**
**US-A-3 827 033**
**US-A-4 203 123**
**US-A-4 234 888**
**US-A-4 240 094**
**US-A-4 295 149**

(73) Proprietor: **JOHNSON, Robert Royce**
**25885 German Mill Road**
**Franklin, Michigan 48025 (US)**

(73) Proprietor: **ENERGY CONVERSION DEVICES, INC.**
**1675 West Maple Road**
**Troy Michigan 48084 (US)**

(72) Inventor: **STOPPER, Herbert**
**4221 Normanwood Drive**
**Orchard Lake, MI 48033 (US)**
Inventor: **FLASCK, Richard A.**
**1346 W. Fairview lane**
**Rochester, MI 48063 (US)**

(74) Representative: **Kirby, Harold Douglas Benson et al**
**G.F. Redfern & Company Marlborough Lodge 14 Farncombe Road**
**Worthing West Sussex BN11 2BT (GB)**

Courier Press, Leamington Spa, England.

**Description**

Background of the invention

This invention relates to hybrid integrated circuits, which are comprised of an interconnection substrate and integrated circuit chips which are mounted on that substrate, and more particularly to a new universal substrate which can be used to interconnect any desired set of chips by any possibly desired wiring diagram.

An integrated circuit is manufactured together with many other similar circuits within a thin slice or wafer of silicon. The final process step applied to wafer manufacture is to saw or break the wafer into individual circuits or chips. Each chip carries a set of bonding pads through which the chip must be connected to other chips and to the outside world. This can either be done by placing each chip into an individual package, wherein a connection is made between each bonding pad and a corresponding package lead and where further external connections are made between package leads, or by placing chips on a substrate whereon interconnections are made from each chip bonding pad to a corresponding substrate bonding pad and where further interconnections between substrate bonding pads are provided by the substrate. The type of bond (wire, beam lead, gold bump, solder ball) is immaterial in the context of this invention. Wire bonding will be used in the following description of the invention for the purpose of explanation only. If the chips are bonded directly to an interconnection substrate, the whole assembly is called a hybrid circuit. This invention relates to using a silicon wafer similar to those used to make individual chips as a substrate for a hybrid circuit.

In the prior art, substrates, which are usually manufactured as multi-layered ceramic plates, provided a limited number of routine channels for the required chip interconnections. It took, therefore, a costly and time consuming automated and/or manual process to devise a suitable interconnection pattern. Furthermore, since most substrates in a system differ from each other, a separate set of tools was needed for the manufacture of each substrate type.

In US—A—3 312 871 a substrate for integrated circuits is described wherein a plurality of parallel connectors is formed at a first level, and an insulating layer is then laid over these first level conductors. Over the insulating layer, a second array of parallel conductors, perpendicular to those of the first level, is laid and at reselected intersections permanent connections are made between conductors of the first and second levels by forming openings in the insulating layer prior to depositing the second level conductors.

In US—A—4 203 123 there is described a memory cell wherein the electrical properties of amorphous semiconductor devices are utilized to store data by providing selectively conductive or non-conductive intersections in a memory array.

Accordingly, the primary object of this invention is to provide a universal substrate which can be programmed to provide any desired interconnection pattern between any set of chips which may be placed on that substrate.

Another object of the invention is to provide routine channels of such numbers and such properties that programming the interconnections can be done effectively and without extensive computer aided or manual layout work.

Still another object of this invention is that programming can be done similar to the known capabilities of ROM and PROM chips either by "mask programming" or by "electrical programming" of a completely finished substrate.

Still another object of this invention is to extend the electrical programming to electrical reprogramming so that logic design errors and/or substrate manufacturing defects can be corrected after the substrate has been finished.

Summary of the invention

The substrate which accomplishes the foregoing objects is a wafer made of silicon or any other material suitable for integrated circuit-type processing. Two layers of interconnection separated by a layer of insulation are deposited and patterned on this wafer. The resolution for patterning the metal on the wafer is such that the two layers of metal provide enough routing channels to interconnect all the chips which can physically be placed on the wafer. The actual routine is provided by a particular pattern of orthogonal lines with a special selection of fixed and programmable cross-points connecting certain lines to each other in such a manner that all possibly desired connections among substrate bonding pads and between substrate bonding pads and the outside world can be made. A fixed connection cross-point or a mask programmable cross-point is made by a via hole entered into the insulator between the metal lines crossing each other, while an electrically programmable connection cross-point is made by placing a pad of amorphous semiconductor material, which can be switched electrically from a high-impedance to a low-impedance state, between the metal lines crossing each other.

Description of the preferred embodiment

Turning now to the drawings in greater detail, I will outline what is shown in each drawing, element by element, and then proceed in more detail.

Figure 1 shows the master wafer in plan view, of which layers will be shown;

Figure 2 is a plan view of the layer portions of the wafer of Fig. 1, showing pad lines;

Figure 3 is a plan view of the layer portion of the wafer of Figure 1 showing net lines;

Figure 4 shows the layer portion of Fig. 1 for power distribution;

Figure 5 shows a cell (2 in Fig. 1) in more detail;

Figure 6 shows a layer of the cell of Fig. 5 showing bonding pads in detail;

Figure 7 is a further detail of Fig. 5;

Figure 8 shows a cross section of Fig. 5 through a cross-over between a pad line and a net line;

Figure 9 is a diagrammatic view of an interconnection between the pads;

Figure 10 is a diagram of a cell (2) of Fig. 1 showing how smaller chips can be bonded in the cell position;

Figure 11 is another diagram showing how to mix chips; and

Figure 12 shows a strip layout.

Brief description of the drawings

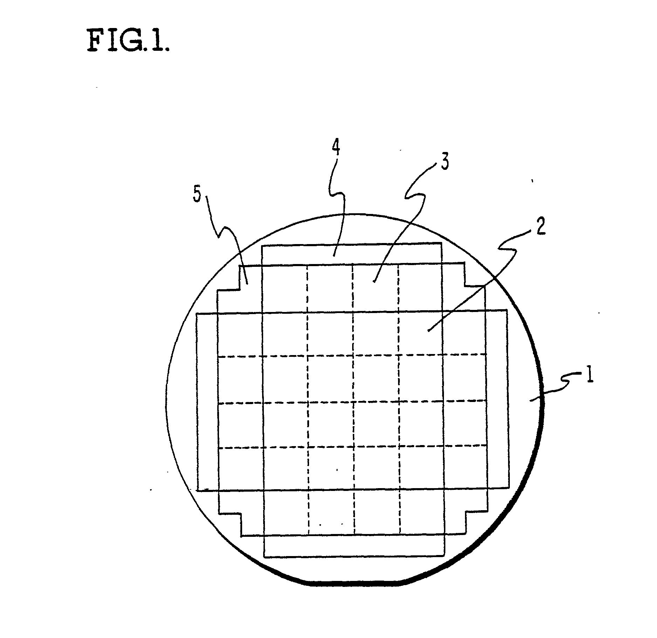

Figure 1 is a plan view of a wafer (1) showing how the available area may be divided up into inner cells (2), outer cells (3), logic line hookup areas (4), and power hookup areas (5).

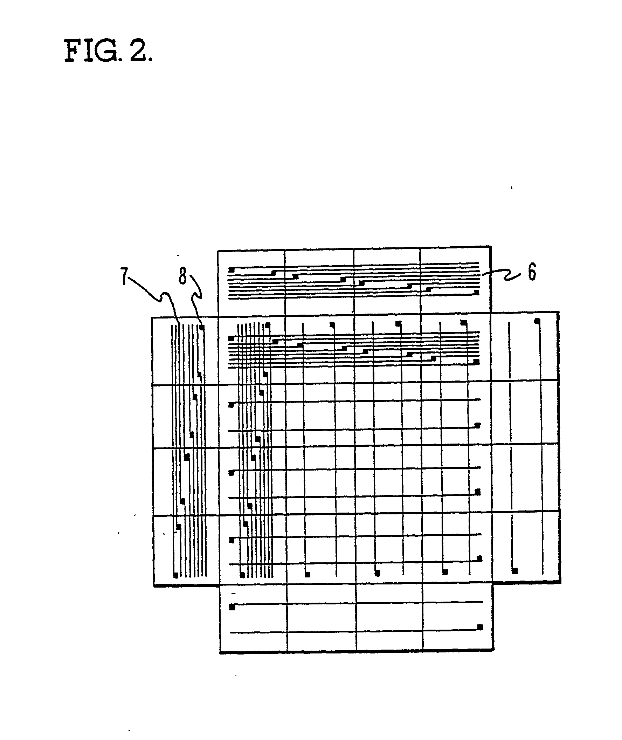

Figure 2 shows horizontal pad lines (6) and vertical pad lines (7) crossing a number of cells in such a way that each pad (8) can be connected to its own pad line. Outer cells are crossed by either horizontal or vertical pad lines. Inner cells are crossed by both horizontal and vertical pad lines.

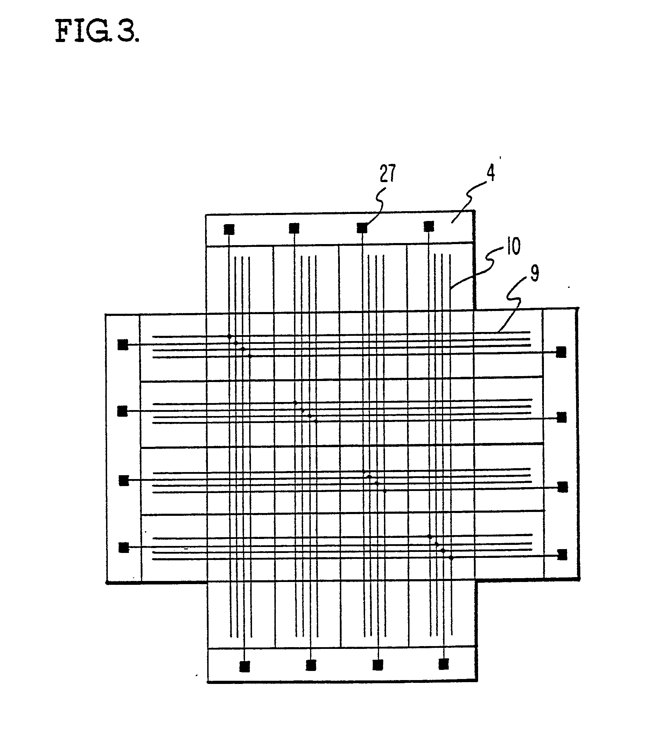

Figure 3 shows horizontal net lines (9) and vertical net lines (10) which cross all cells in such a way that each horizontal pad line (6) is crossed by each vertical net line (10) and each vertical pad line (7) by each horizontal net line (9). Each horizontal net line (9) is connected permanently to exactly one vertical net line (10) and to exactly one contact pad (27) in one of the hookup areas (4). Thus, all pad lines cross all nets and all nets can be externally accessed.

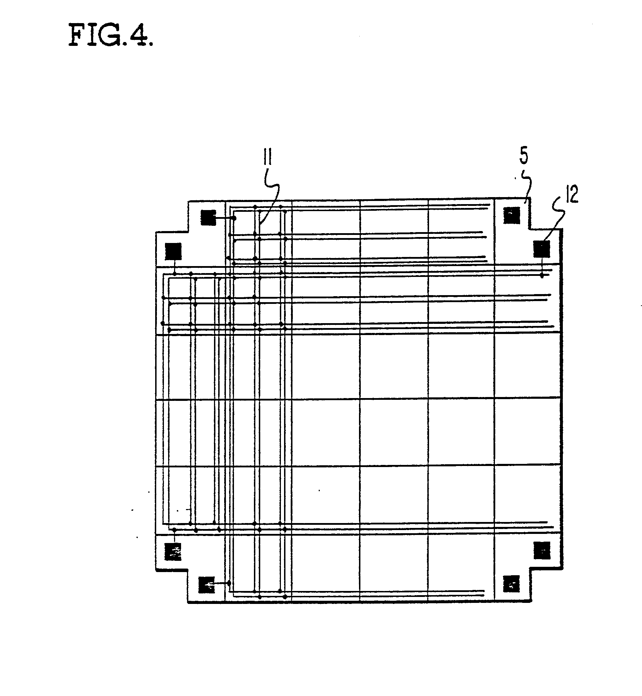

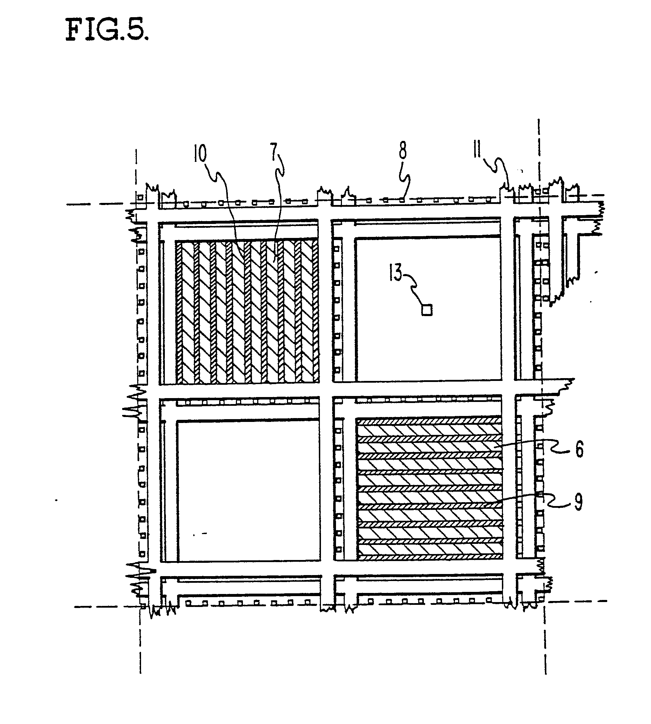

Figure 4 shows a power grid (11) for a two rail power distribution system. Each cell is crossed by both rails three times in both the horizontal and vertical directions. The power rails are connected to a pair of contact pads (12) in each power hookup area (5). Figure 5 shows an inner cell with some more detail. Power grid (11) bonding pads (8), pad lines (6 & 7), and net lines (9 & 10) share the available space in such a way that only two metal planes are needed and that no wires are found under a bonding pad.

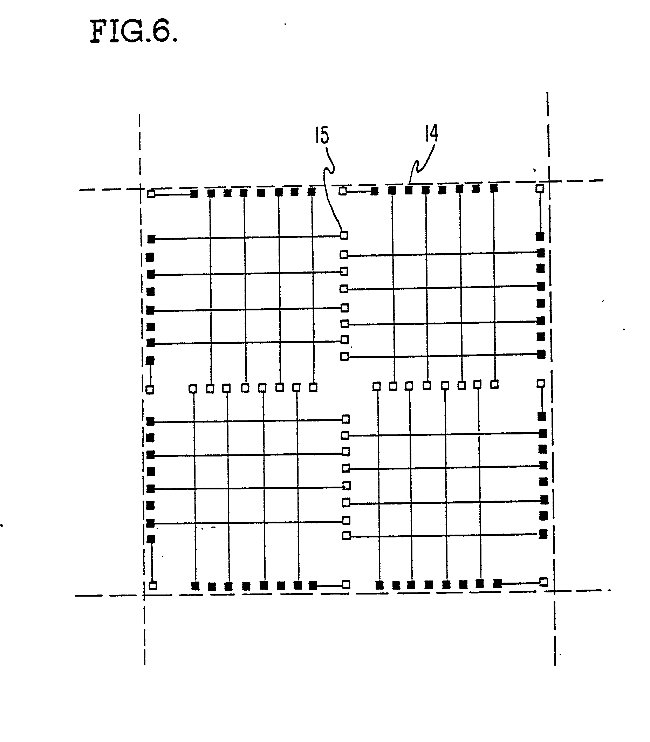

Figure 6 shows that a cell contains main bonding pads (14) and auxiliary bonding pads (15). Only main pads command their own pad lines as shown in Figure 2. An auxiliary pad is connected to a next neighbor main pad.

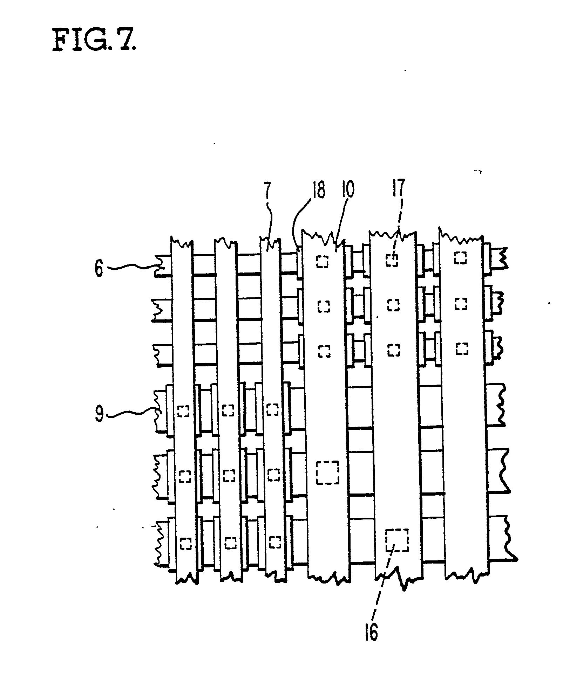

Figure 7 shows a detail (13) as it may be found in Figure 5. The narrow lines are pad lines 6 and 7, and the wide lines are net lines 9 and 10. Crossovers between pad lines are insulated. Crossovers between net lines are generally also insulated except that each horizontal net line is connected through a via hole (16) at one point to a vertical net line. Cross-overs between pad lines and net lines have a via hole (17) cut into the insulator between the metal layers and have a pad of amorphous semiconductor (18) sandwiched in between.

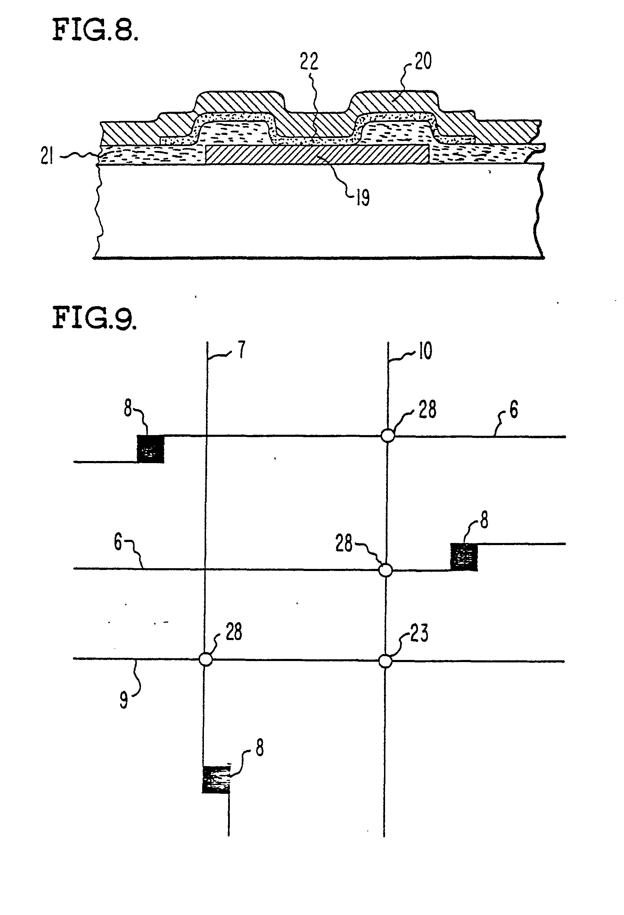

Figure 8 shows a cross section through a crossover between a pad line and net line. Lower level metal (19) is generally separated from upper level metal (20) by the insulator (21) except for the via hole within the insulation where the metals are separated from each other by the amorphous semiconductor material (22).

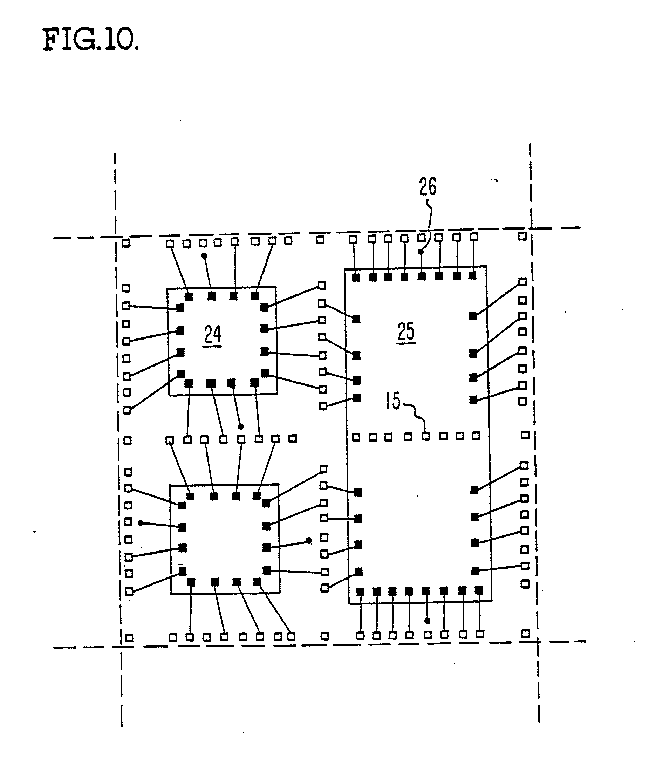

Figure 9 shows how the desired interconnection between three pads (8) is made by selecting two orthogonal net lines (9 & 10) which are permanently connected to each other by via holes (23) and by firing the controllable cross-points (28) between the applicable pad lines (6 & 7) and the chosen net.

Figure 10 shows how smaller chips (24 & 25) which require less area and a smaller number of pads then provided by a cell can be accommodated efficiently. Some unused pads (15) are buried under the chip. Power connections (26) are made directly to one of the power rails and not to a pad (8).

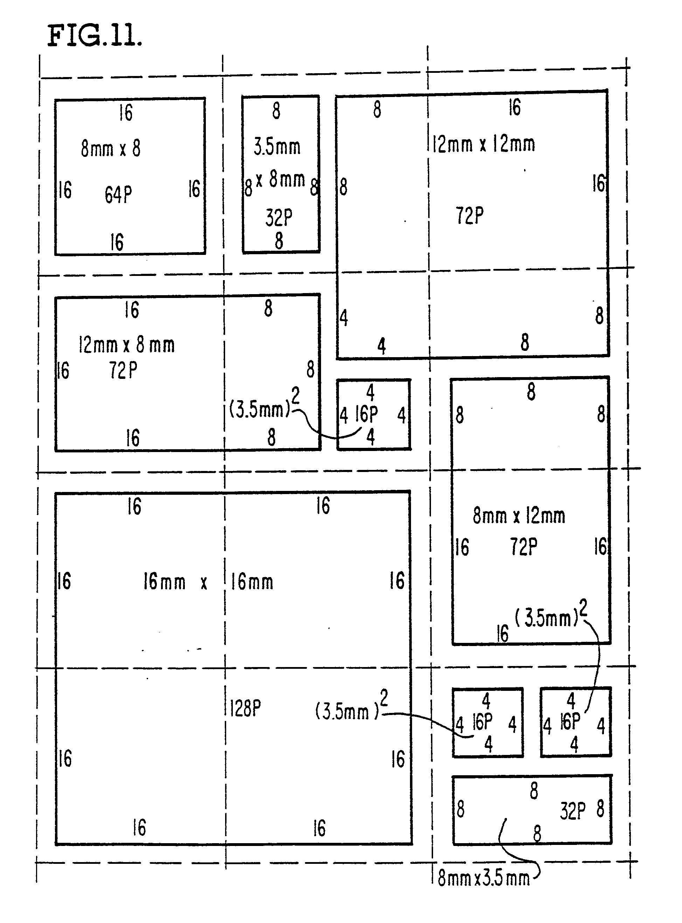

Figure 11 shows how a mixture of chips which require larger, equal, and smaller areas than provided by a cell can be accommodated. The numbers within the chip symbols indicate maximum size and available logic signal pads.

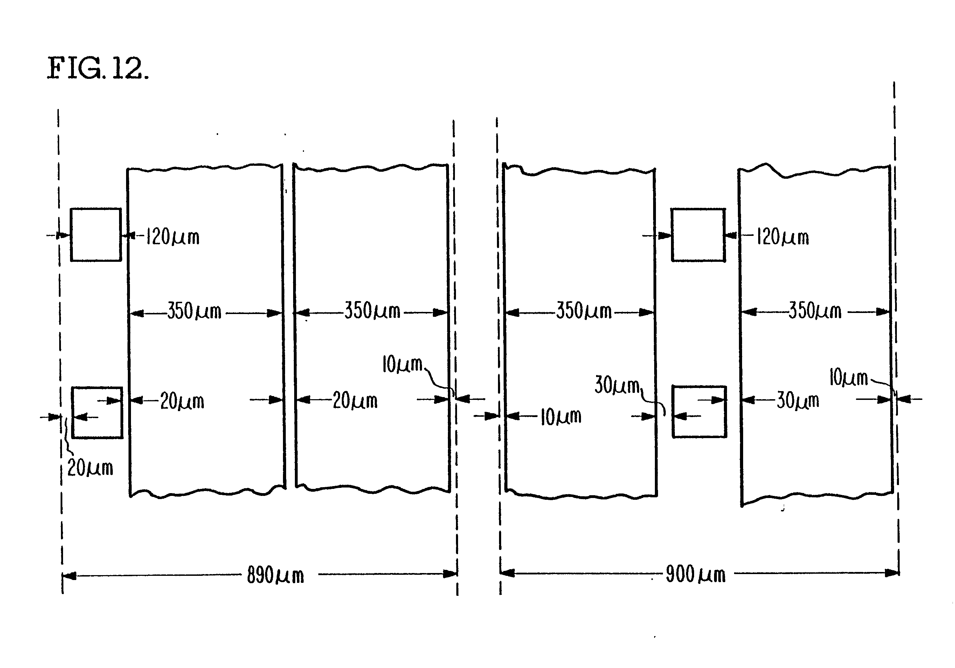

Figure 12 shows how the strips containing the power buses and the bonding pads are layed out.

From the above, it will be seen that the drawings disclose a substrate (1) which by itself may be made either of conductive or non-conductive material. This substrate carries two planes or layers of patterned metal (19, 20), thus providing two principal levels of interconnection. An insulation layer (21) is placed between the metal layers and also between the lower metal layer and the substrate if the latter is conductive. Connections between the metal layers or between the metal layer and the substrate can be made through via holes in the insulator layer or layers, respectively.

The real estate provided by the substrate (1) is divided up into special areas used for inner cells (2) and outer cells (3) signal hookup areas (4) and power hook-up areas (5). In one preferred embodiment, the substrate may be a disk with a diameter of 75 mm, the cells may be squares with edges of 9 mm, the signal hookup areas may be rectangles with sides of 4.5 mm and 36 mm, and the power hookup areas may fill out the remaining space in the "corners".

The cells are intended to host the integrated circuit chips (24, 25) and to provide the bonding pads (8) for the signal connections between the chips and the substrate. In the preferred embodiment, the inner cells provide sixty-four signal pads each so that LSI chips with up to sixty-four leads and with a physical size of up to 8 mm by 8 mm can be accommodated. Chips which are substantially smaller than the possible maximum in terms of physical size and signal leads can share a cell as shown by example in Figure 10. Since bond wires cannot jump over a neighbor chip to find a substrate bonding pad, auxiliary pads (15) are provided which are connected with the main pads (14) through the substrate (Figure 6). Over-size chips which are either larger than 8 mm by 8 mm or which require more than sixty-four bonding pads can be stretched over 2 or more cells or any quadrants thereof. Figure 11 shows some examples. The maximum chip size and number of available bonding pads is inscribed within the outline of a chip. It is also possible that bonding pads can be borrowed from another cell or quarter cell along the common edge between 2 cells. Since some pads will be buried under the chips, the back of the chips is insulated from these pads by suitable means as, for instance, chip bonding with non-conductive epoxy. All in all, it can be seen that the substrate can be universally used for any combination of chip sizes.

Some chips, particularly dynamic MOS RAM chips, have the unique characteristic that their aspect ratio is approximately 2:1 and that the chip bonding pads are located along the 2 smaller sides of the chip. Such chips can be accommodated more economically by reduced cells which provide bonding pad only in one direction. Such cells are shown in the preferred embodiment as outer cells. They are derived from complete cells by omitting either the horizontal or the vertical rows of bonding pads. RAM chips would be placed into an outer cell-like chip (25) shown in Figure 10 except that all vertical pad columns on the chip as well as on the substrate would have been eliminated.

Power supply connections have been separated from logic signal connections because they must provide lower series resistance. Since it is not known in advance where the power inputs of a particular chip may be located, it is not possible to assign power pads on the substrate. This problem has been solved by providing 2 power buses (11) along the edges and along the center lines of all cells. A chip power pad which may be located anywhere along the edge of the chip can now be connected to a power bus instead of a substrate pad with a bond (26).

The power buses form a power grid over the entire substrate as shown in Figure 4. The width of a power bus may be 350 µm. If implemented with 1 µ m-thick aluminum, which yields a sheet resistivity of 30 mΩ/□, the longitudinal resistance would amount to 86 mΩ/mm. If the actual loads are known, the voltage drops in the power system can be computed accordingly. For a general approximation, one can work with a "power sheet" instead of a "power grid" whereby the equivalent power sheet resistivity is derived from the actual sheet resistivity o by multiplying it with the ratio between cell width and bus width.

$$\rho = \frac{\text{cell width}}{\text{bus width}} \qquad \rho_0 = \frac{9 \text{ mm}}{3 * 0.35 \text{ mm}}$$

$$* 30 \text{ m}\Omega/\square = 257 \text{ m}\Omega/\square$$

If a disk with the radius R is loaded over its entire surface with a current density j, and if the periphery of the disk is held at ground poatential, then the point with the highest potential is found at the centre of the disk and the voltage U betweem the center and the periphery is found to be

$$U = \frac{\rho j R^2}{4}$$

$\rho = .257 \ \Omega$, $2R = 75$ mm, and $j = lo/(9 \text{ mm})^2$ yields $U = 1.12 \ \Omega * lo$. Thus, for a load of 1 amp per cell, the voltage drop from the power hookup to the center of the wafer would be approximately 1 volt.

One has now to consider two basic types of circuits: "symmetrical circuits" as, for instance, CMOS and "unsymmetrical circuits" as, for instance, NMOS. For symmetrical circuits, which have a threshold centered between the power rails, the power grid as described so far is adequate. The supply voltages at the substrate edge may be 0 and +5 volts. The threshold would then be set by a chip-internal voltage divider to approximately 2.5 volts. A chip at the center would see voltage drops of approximately 1 volt at each power rail, i.e., the power input voltages would be +1 and +4 volts. The threshold of the circuit at the center would again be halfway between the power rails, i.e., at +2.5 volts so that all circuits on the wafer could properly communicate with each other.

In unsymmetrical circuits, all thresholds are referenced to one of the power rails (usually ground) and more or less independant from the other power rail. In this case, the voltage drop along the reference rail must be relatively small. This can be accomplished by using a solid ground sheet under the two metal layers discussed above and by making via connections between the ground grid and this sheet at several points per cell. If the ground sheet is comprised of a conductive silicon wafer with an additional layer of 2 µm-thick aluminum a sheet resistivity of 10 mΩ/□ may be accomplished. Based on the same formula used above, the maximum voltage drop can be estimated to be $U = 0.04 \ \Omega * lo$ or approximately 0.04 volts for cell currents of 1 amp each. This value is acceptable for most circuits.

The next problem to be solved by this invention is to interconnect all substrate pads with each other in any possibly desired way and also to connect any or all pads to the outside world. This is accomplished by a set of pad lines (6, 7) and a set of net lines (9, 10). A pad line is permanently connected to exactly one pad (8). Thus, there are as many pad lines on the substrate as there are pads, whose number is

$$16*64 + 16*32 = 1,536$$

in the preferred embodiment. A pad line is routed either horizontally or vertically across the substrate for a certain distance. As can be seen in Figure 2, the principal wiring pattern is such that, if a horizontal set of pad lines serves n columns of pads, there must be (n−1) pad lines passing between two pads of one and the same column.

Net lines are also routed either horizontally or vertically across the substrate. One horizontal net line (9) and one vertical net line (10) are permanently connected to each other, thus forming a net. Each net is connected to one contact pad (27) in one of the hookup areas (4). One preferred embodiment of the invention provides a total of 288 nets. Since the hookup areas are 36 mm long, the resulting contact pitch is 0.5 mm. Another preferred embodiment provides 432 nets, causing a 0.33 mm pitch for the peripheral contacts (27).

The combined routing pattern of pad lines and net lines is such that each pad line crosses each net exactly one time, which can be seen by combining Figure 2 and Figure 3. A number of pads can now be connected to each other by choosing a net and by making (programmable) connections at the cross-over points between this net and the respective pad lines (Figure 9).

If one assumes that no more than 1,300 of the 1,536 available pads are actually used, the number of 288 nets would be adequate if the average fan-out is larger than $1,300/288 - 1 = 3.5$. Accordingly, 432 nets would be adequate for an average fan-out of at least 2. Once an adequate number of nets have been chosen, one can truly say that all thinkable pad interconnection patterns can be derived from one standard set of lines.

In the preferred embodiment, the length of a pad line is 33 mm, and the length of a net line is approximately 42 mm (from one end to the farthest possible via). If the sheet resistivity of the metal is 30 mΩ/□, the longitudinal resistivity of a 10 µm wide pad line would be 3 Ω/mm and that of a 20 µm wide net line would be 1.5 Ω/mm.

The total resistance of a pad line amounts then to 100 Ω and that of a net line is 63 Ω. The longest possible interconnection from, say, a pad in the upper left corner to a net line at the far right, then down to the net line at the bottom, then to the far left side, and finally up along another pad line to another pad in the upper left corner would amount to 326 Ω, a large value for a line between two pads which are located close to each other. An average connection would of course, be much better. The best connection, however, is realized by choosing a net whose junction between its horizontal and vertical net lines is as close as possible to the pads which have to be tied together. It is, therefore, part of this invention to arrange the junctions (23) between the net lines not on a simple diagonal line as indicated for the small representative number of lines in Figure 3, but rather in such a way that they are evenly distributed over the total field of inner cells. This provides a high probability that a net with a close-by junction can be found in all cases. The average connection length should thereby be reduced to about 1/5 of the maximum or to approximately 70 Ω.

The actual programming or firing of a cross-over between a pad line and a net line can be done in one or two ways, either by a normal via hole or by an electrically switchable link. The first method could be called "mask programming" as the term is applied in prior art to ROM chips. The disadvantage of this method is that a new via hole mask must be prepared for each new interconnection pattern and that, therefore, a large number of different part numbers must be handled in the manufacturing process. The advantage is that, in case of large volumes per part numbers, the simple via reduces manufacturing costs over other methods and that the direct via does not introduce substantial series resistance.

The second method solves the individual mask and the part number problem by programming the desired interconnection electrically after the substrate has gone through the complete manufacturing process. In order to facilitate this programming, all cross-overs between pad lines and net lines have a permanent via (17) cut through the insulator between them, which is then covered up by a pad (18) of chalcogenide or amorphous semiconductor material as shown in Figures 7 and 8. Net lines 9, 10) are shown in Figure 7 as the wider lines (20 µm), while pading lines (6, 7) are shown as the narrow lines (10 µm). The useful characteristic of the amorphous switch for this application is that it provides originally an insulator which can be transformed into a con-ductor (approximately 100 Ω resistance per junc-tion) if a voltage higher than a threshold voltage is applied. If the threshold voltage is set by design to be sufficiently higher than the operating voltages of the chips, accidental firing during later use is prevented. For intended firing, a voltage higher than the threshold voltage is applied by raising the potential of the applicable net line via the edge contact provided for each net and by lowering the potential of the applicable pad line via the pad. All other net lines are either tied to ground or kept floating, and all other pad lines are also either kept floating or tied indirectly to the ground via an already fired cross-point and a net line. Thus, cross-points which are not to be fired are only exposed to about half of the total voltage or are isolated through a large series impedance. The total firing voltage must be chosen such that it is larger than the threshold voltage but smaller than twice the threshold voltage.

The pads (18) are shown in Figure 7 and Figure 8 only in those locations where they are needed for the intended function. For the convenience of processing and other considerations, however, the pad area can be extended. Particularly, all pads in a vertical column can be made as contiguous strips, running in parallel under the upper level metal lines. This configuration would still provide perfect insulation between all lines even if the amorphous material had some noticeable residual conductivity in the unfired state. A further step would be to extend the amorphous material as a sheet over the total substrate. Covering cross-overs which must not be switched is harmless because firing of the material is prevented by an insufficient firing voltage and by the series insulator (21).

Once a cross-point has been fired, the voltages of the now connected pad lines and net lines are forced to be more or less equal, which precludes further independent programming. Consequently, a net line can be tied to more than one pad line, but a pad line can only be tied to one net line. This restriction, however, does not interfere with the intended method of constructing nets as shown in Figure 9.

For the mechanical aspects of programming, it is important to note that not all of the 1,536 bonding pads and the 288 or 432 contact pads need to be accessed simultaneously. Actually, accessing one bonding pad plus one contact pad at a time is sufficient. Practically, a compromise between serial mechanical accessing and electrical switching between pads accessed mechanically and in parallel will be chosen. Though the substrate in the preferred embodiment of the invention carries only the wiring and the amorphous switches, it is also part of this invention that access switching logic for net lines can be integrated into a silicon wafer used as a substrate, for instance within the signal access areas (4).

Pads, pad lines, net lines, and power buses share the available space in the two metal layers as shown in Figure 5. All pads (14, 15) are placed in the upper layer so that bonds can be made. The lower level space under the pads is not used because bonding may cause tiny cracks in the insulator which could lead to shorts with the lower layer metal. The power buses (11) are also part of the upper layer so that bonds can be made to it. An exception is the cross-over between two buses. Here, one bus dives through under the other bus. Net lines (9, 10) do not need to come to the surface except for the contact pads (27) in the contact areas (4). Horizontal net lines (9) may be placed into the lower layer as indicated in Figure 7. They dive through under the power grids and avoid the bonding pads. Vertical net lines (10) may be placed in the upper layer. At the edge of the open fields between the power grids they have to dive to the lower layer so that they can also pass the grids. Note that the required lower level space is available because no other horizontal lines run under the power grids. Horizontal pad lines (6) run in the lower level just as the horizontal net lines (9) except that a via connection must be made to the bonding pads (14, 15). Note that the pad lines do not run under the bonding pads but rather in the space between them though lines and pads are in different layers. This is accomplished by fitting the pads between the lines as sketched in Figure 2. The auxiliary pads (15) which have not been shown in Figure 2 can be connected the same way because they are topologically adjacent to their respective main pads (14). The vertical pad lines (7) are placed together with their pads into the upper layer but must dive together with the vertical net lines in order to pass the horizontal power buses. The auxiliary pads (15) are connected to their respective pad lines through vias.

Outer cells have the same power grids but only one-half of the net and pad lines is shown in Figure 2 and 3. Their wiring pattern is a direct subset of that used for inner cells.

The space of a 9 mm cell may be allocated to the major areas as shown in Figure 5: 0.89 mm each for the edge strips containing main bonding and two power buses, 0.9 mm for the center strip containing auxiliary pads and two power buses, and 3.16 mm each for the fields which contain each 8 pad line strips and 9 net line strips. The edge and center strips may be divided down further as shown in Figure 12. A net line strip which is 120 μm wide can be used either for four 20 μm-lines and four 10 μm-spaces or for six 10 μm-lines and six 10 μ/m-spaces. A pad line strip which is 260 μm wide can be used for one 120 μm pad, seven 10 μm-lines, and seven 10 μm spaces.

It has been shown that any desired interconnection pattern can be programmed. This flexibility can also be used to correct manufacturing defects. If spare pads and spare net lines are available, a given set of defects can be neutralized simply by not using any affected pads or nets. Since it is known that certain amorphous chalogenide materials cannot only be switched into the conductive state but also back into the non-conductive state, the usage of such materials would not only allow for programming but also for reprogramming. Reprogramming can then be used to neutralize even such defects which are discovered or which occur only after the initial programming.

**Claims**

1. A substrate for integrated circuitry comprising a base substrate wafer having disposed thereon a first conductive interconnection layer (19) and a second conductive interconnection layer (80) and a layer (21) of insulation separating said first and second interconnection layers,

said base substrate being adapted for carrying a plurality of integrated circuit chips thereon, and

said first and second interconnection layers being adapted to provide a routing network between said integrated circuit chips by a pattern of interconnection lines for each layer,

said first and second interconnection layers being interconnected by through vias through said insulating layer at cross-points connecting a line in said first interconnection layer with a line in said second interconnection layer characterised in that at least one of said cross-points is a programmable cross-point wherein said connection is made through an amorphous semiconductor material which can be switched electrically from a high impedance to a low impedance state.

2. A substrate according to claim 1, characterised in that the amorphous semiconductor material is an amorphous chalcogenide.

3. A substrate according to claim 1, characterised in that integrated circuits are bonded to the substrate to form a hybrid circuit.

4. A substrate according to claim 1, characterised in that the base substrate is composed of silicon material.

5. A substrate according to claim 1, characterised in that the substrate is divided into a plurality of areas, respective ones of the areas being adapted to act as inner cells, outer cells, signal hookup areas and power hookup areas.

6. A substrate according to claim 1, characterised in that areas of the substrate are provided as cells adapted to host integrated circuit chips and to provide bonding pads for signal connections between the chips and the substrate.

7. A substrate according to claim 6, characterised in that at least one of the cells has a plurality of signal pads disposed therein.

8. A substrate according to claim 7 having disposed thereon an integrated circuit chip in each of the cells.

9. A substrate according to claim 7, characterised in that the cells are adapted to receive chips covering an area larger that that cell area.

10. A substrate according to claim 7, characterised in that the cells are adapted to receive chips covering an area smaller that that cell area.

11. A substrate accordint to claim 7, characterised in that the cells are adapted to receive chips covering an area substantially equal to those of the cells.

12. A substrate according to claim 7, characterised in that cells are provided on the substrate which are adapted to be universally usable for a combination of chip sizes.

13. A substrate according to claim 1, characterised in that cells are provided on the substrate adapted to receive chips bonded thereto and having signal bonding pads for signal connection between the chips and the substrate, and power busses are provided along the edges of all cells.

14. A substrate according to claim 13, characterised in that additional power busses are provided along the centre lines of the cells.

15. A substrate according to claim 1, characterised in that the lines of the first and second interconnection layers form an orthogonal line pattern.

16. A substrate according to claim 1, characterised in that the interconnecting lines comprise a plurality of pad lines each having a single pad, and a plurality of net lines.

17. A substrate according to claim 1, characterised in that the interconnecting lines comprise a set of pad lines, a set of horizontal net lines and a set of vertical net lines disposed perpendicularly to the horizontal net lines, each horizontal net line being connected to a single vertical net line to form a net, and each net being connected to a single pad.

18. A substrate according to claim 17, characterised in that each pad line crosses each net once.

19. A substrate according to claim 1, characterised in that the said at least one programmable cross-point is formed by an opening (17) in the layer of insulation between the first and second conductive insulating layers, the opening being filled by a cross-point pad (18) of amorphous semiconductor material which is an insulator and can be switched electrically to be a conductor by the application of a voltage higher than a predetermined voltage.

20. A substrate according to claim 19, wherein a plurality of conductive lines are formed in one of conductive interconnecting layers, and at least one said conductive lines has a plurality of programmable cross-point pads of amorphous semiconductor material for these cross-points are formed by a single continuous strip running between the said conductive line and the insulating layer.

21. A substrate according to claim 19, characterised in that the amorphous semiconductor material is applied as a coating between the insulating layer and one of the conductive layers.

22. A substrate according to claim 1, characterised in that the substrate has a conductive base substrate wafer in contact with a power grid such that power connections may be made directly to a power rail of said grid.

**Patentansprüche**

1. Substrat für integrierte Schaltungen mit einem Basissubstrat-Wafer, auf dem eine erste leitfähige Verbindungsschicht (19) und eine zweite leitfähige Verbindungsschicht (80) und eine Isolationsschicht (21) angeordnet sind, welche die erste und zweite Verbindungsschicht trennt, wobei das Basissubstrat dazu eingerichtet ist, eine Vielzahl von integrierten Schaltungschips zu tragen, und die erste und zweite Verbindungsschicht dazu eingerichtet sind, ein Leitweg-Netzwerk zwischen den integrierten Schaltungschips durch eine Struktur von Verbindungsleitungen für jede Schicht zur Verfügung zu stellen, wobei die erste und zweite Verbindungsschicht über Durchgangsleitungen durch die Isolationsschicht an Kreuzungsstellen verbunden sind, die eine Leitung in der ersten Verbindungsschicht mit einer Leitung in der zweiten Verbindungsschicht verbinden, dadurch gekennzeichnet, daß wenigstens eine der Kreuzungsstellen eine programmierbare Breuzungsstelle ist, bei der die Verbindung durch ein amorphes Halbleitermaterial gebildet ist, das elektrisch von einem Zustand hoher Impedanz in einen Zustand geringer Impedanz umgeschaltet werden kann.

2. Substrat nach Anspruch 1, dadurch gekennzeichnet, daß das amorphe Halbleitermaterial ein amorphes Chalcogenid ist.

3. Substrat nach Anspruch 1, dadurch gekennzeichnet, daß die integrierten Schaltungen mit dem Substrat verbunden sind, um eine Hybridschaltung zu bilden.

4. Substrat nach Anspruch 1, dadurch gekennzeichnet, daß das Basissubstrat aus Siliziummaterial zusammengesetzt ist.

5. Substrat nach Anspruch 1, dadurch gekennzeichnet, daß das Substrat in eine Vielzahl von Gebieten geteilt ist, wobei jeweils einige von den Gebieten dazu eingerichtet sind, als innere Zellen, äußere Zellen, Signal-Anschlußgebiete und Strom-Anschlußgebiete zu dienen.

6. Substrat nach Anspruch 1, dadurch gekennzeichnet, daß Gebiete des Substrats als Zellen vorgesehen sind, die dazu eingerichtet sind, integrierte Schaltungschips aufzunehmen und Verbindungsflächen für Signalverbindungen zwischen den Chips und dem Substrat zur Verfügung zu stellen.

7. Substrat nach Anspruch 6, dadurch gekennzeichnet, daß wenigstens eine der Zellen eine Vielzahl von Signal-Anschlußflächen hat, die darauf angeordnet sind.

8. Substrat nach Anspruch 7, auf dem ein integrierter Schaltungschip in jeder der Zellen angeordnet ist.

9. Substrat nach Anspruch 7, dadurch gekennzeichnet, daß die Zellen dazu eingerichtet sind, Chips aufzunehmen, die ein größeres Gebiet als das Zellgebiet bedecken.

10. Substrat nach Anspruch 7, dadurch gekennzeichnet, daß die Zellen dazu eingerichtet sind, Chips aufzunehmen, die ein kleineres Gebiet als das Zellgebiet bedecken.

11. Substrat nach Anspruch 7, dadurch gekennzeichnet, daß die Zellen dazu eingerichtet sind, Chips aufzunehmen, die ein Gebiet bedecken, das dem der Zellen im wesentlichen gleich ist.

12. Substrat nach Anspruch 7, dadurch gekennzeichnet, daß auf dem Substrat Zellen vorgesehen sind, die dazu eingerichtet sind, für eine Kombination von Chip-Größen universell verwendbar zu sein.

13. Substrat nach Anspruch 1, dadurch gekennzeichnet, daß auf dem Substrat Zellen vorgesehen sind, die dazu eingerichtet sind, damit verbundene Chips aufzunehmen und Signal-Anschlußflächen für die Signalverbindung zwischen den Chips und dem Substrat haben, wobei Stromleitungen längs der Kanten aller Zellen vorgesehen sind.

14. Substrat nach Anspruch 13, dadurch gekennzeichnet, daß zusätzliche Stromschienen entlang der Mittellinien der Zellen vorgesehen sind.

15. Substrat nach Anspruch 1, dadurch gekennzeichnet, daß die Leitungen der ersten und zweiten Verbindungsschicht eine orthogonale Leitungsstruktur bilden.

16. Substrat nach Anspruch 1, dadurch gekennzeichnet, daß die Verbindungsleitungen eine Vielzahl von Anschlußleitungen aufweisen, von denen jede eine einzelne Anschlußfläche hat und eine Vielzahl von Netzleitungen.

17. Substrat nach Anspruch 1, dadurch gekennzeichnet, daß die Verbindungsleitungen eine Gruppe von Anschlußleitungen, eine Gruppe von horizontalen Netzleitungen und eine Gruppe von vertikalen Netzleitungen aufweisen, die zu den horizontalen Netzleitungen senkrecht angeordnet sind, wobei jede horizontale Netzleitung mit einer einzelnen veritkalen Netzleitung verbunden ist, um ein Netz zu bilden, und daß jedes Netz mit einer einzelnen Anschlußfläche verbunden ist.

18. Substrat nach Anspruch 17, dadurch gekennzeichnet, daß jede Anschlußleitung jedes Netz einmal kreuzt.

19. Substrat nach Anspruch 1, dadurch gekennzeichnet, daß wenigstens eine programmierbare Kruezungsstelle durch eine Öffnung (17) in der Isolationsschicht zwischen der ersten und zweiten leitfähigen Isolationsschicht gebildet ist, wobei die Öffnung mit einer Kreuzungsstelle-Anschlußfläche (18) aus amorphem Halbleitermaterial gefüllt ist, das einen Isolator darstellt und elektrisch durch Anlegen einer Spannung, die höher als eine vorbestimmte Spannung ist, als Leiter geschaltet werden kann.

20. Substrat nach Anspruch 19, wobei eine Vielzahl von leitfähigen Leitungen in eine der leitfähigen Verbindungsschichten gebildet sind, und wenigstens eine der leitfähigen Leitungen eine Vielzahl von programmierbaren Kreuzungsstelle-Anschlußflächen aus amorphem Halbleitermaterial für diese Kreuzungsstellen hat, die durch einen einzelnen fortlaufenden Streifen gebildet werden, der zwischen der leitfähigen Leitung und der Isolationsschicht verläuft.

21. Substrat nach Anspruch 19, dadurch gekennzeichnet, daß das amorphe Halbleitermaterial als eine Beschichtung zwischen der Isolationsschicht und einer der leitfähigen Schichten aufgebracht wird.

22. Substrat nach Anspruch 1, dadurch gekennzeichnet, daß das Substrat einen leitfähigen Basissubstrat-Wafer in Kontakt mit einem Stromnetz hat, so daß stromverbindungen mit einer Stromschiene des Netzes direkt gemacht werden können.

**Revendications**

1. Substrat pour circuits intégrés comprenant une plaquette de substrat de base sur laquelle sont disposées une première couche d'interconnexion conductrice (19) et une seconde couche d'interconnexion conductrice (80) et une couche (21) d'isolement séparant lesdites première et seconde couches d'interconnexion,

ledit substrat de base étant prévu pour porter sur sa surface une pluralité de puces à circuits intégrés, et

lesdites première et seconde couches d'interconnexion étant prévues pour fournir un réseau d'acheminement entre lesdites puces à circuits intégrés par un schéma de lignes d'interconnexion pour chaque couche,

lesdites première et seconde couches d'interconnexion étant interconnectées par l'intermédiaire de transits à travers ladite couche d'isolement en des points de croisement connectant une ligne dans ladite première couche d'interconnexion avec une ligne située dans ladite seconde couche d'interconnexion, caractérisé en ce qu'un desdits points de croisement au moins est un point de croisement programmable dans lequel ladite connexion est effectuée à travers un matériau semi-conducteur amorphe qui peut être commuté électriquement d'un état de haute impédance à un état de basse impédance.

2. Substrat selon la revendication 1, caractérisé en ce que le matériau semi-conducteur amorphe est un chalcogénure amorphe.

3. Substrat selon la revendication 1, caractérisé en ce que les circuits intégrés sont connectés au substrat pour former un circuit hybride.

4. Substrat selon la revendication 1, caractérisé en ce que le substrat de base est composé d'un matériau de silicium.

5. Substrat selon la revendication 1, caractérisé en ce que le substrat est divisé en une pluralité de zones, des zones respectives étant prévues pour agir en tant que cellules internes, cellules externes, zones de connexion de signal et zones de connexion de puissance.

6. Substrat selon la revendication 1, caractérisé en ce que des zones du substrat sont réalisées en tant que cellules prévues pour recevoir des puces à circuits intégrés et pour fournir des bornes de liaison servant aux connexions de signal entre les puces et le substrat.

7. Substrat selon la revendication 6, caractérisé en ce que au moins une des cellules comporte en elle une pluralité de bornes de signal.

8. Substrat selon la revendication 7, sur lequel sont une puce à circuit intégré est disposée à l'intérieur de chacune des cellules.

9. Substrat selon la revendication 7, caractérisé en ce que les cellules sont prévues pour recevoir des puces couvrant une surface plus grande que la surface de cellule.

10. Substrat selon la revendication 7, caractérisé en ce que les cellules sont prévues pour recevoir des puces couvrant une surface plus petite que la surface de cellule.

11. Substrat selon la revendication 7, caractérisé en ce que les cellules sont prévues pour recevoir des puces couvrant une surface sensiblement égale à celle des cellules.

12. Substrat selon la revendication 7, caractérisé en ce que les cellules qui sont réalisées sur le substrat sont prévues pour être universellement utilisables pour une combinaison de dimensions de puces.

13. Substrat selon la revendication 1, caractérisé en ce que des cellules sont réalisées sur le substrat prévu pour recevoir des puces liées à elles, et ayant des bornes de liaison de signal servant à la connexion de signal entre les puces et le substrat, et des bus de puissance sont prévus le long des bords de toutes les cellules.

14. Substrat selon la revendication 13, caractérisé en ce que des bus de puissance supplémentaires sont prévus le long des lignes centrales des cellules.

15. Substrat selon la revendication 1, caractérisé en ce que les lignes de première et seconde couches d'interconnexion forment un schéma de lignes orthogonales.

16. Substrat selon la revendication 1, caractérisé en ce que les lignes d'interconnexion comprennent une pluralité de lignes de bornes dont chacune comporte une seule borne et une pluralité de lignes de réseaux.

17. Substrat selon la revendication 1, caractérisé en ce que les lignes d'interconnexion comprennent un ensemble de lignes de bornes un ensemble de lignes de réseaux horizontales et un ensemble de lignes de réseaux verticales disposées perpendiculairement aux lignes de réseau horizontales, chaque ligne de réseau horizontale étant connectée à une seule ligne de réseau verticale pour former un réseau, et chaque réseau étant connecté à une seule borne.

18. Substrat selon la revendication 17, caractérisé en ce que chaque ligne de borne croise une fois chaque réseau.

19. Substrat selon la revendication 1, caractérisé en ce que ledit au moins un point de croisement programmable est formé par une ouverture (17) pratiquée dans la couche d'isolement entre les première et seconde couches conductrices, l'ouverture étant remplie par une borne de point de croisement (18) d'un matériau semi-conducteur amorphe qui est un isolant et peut être commuté électriquement pour être conducteur par l'application d'une tension plus élevée qu'une tension pré-déterminée.

20. Substrat selon la revendication 19, dans lequel une pluralité de lignes conductrices est formée dans une des couches d'interconnexion conductrices, et au moins une desdites lignes conductrices comporte une pluralité de bornes de points de croisement programmables composée d'un matériau semi-conducteur amorphe du fait que ces points de croisement sont formés par une seule bande continue se trouvant entre ladite ligne conductrice et la couche isolante.

21. Substrat selon la revendication 19, caractérisée en ce que le matériau semi-conducteur amorphe est appliquée sous la forme d'un revêtement entre la couche isolante et l'une des couches conductrices.

22. Substrat selon la revendication 1, caractérisé en ce que le substrat en comporte une plaquette de substrat de base conductrice en contact avec une grille de puissance telle que des connexions de puissance peuvent être réalisées directement sur un rail de puissance de ladite grille.

# FIG.1.

1

FIG. 2.

# FIG. 3.

FIG.4.

# FIG.5.

# FIG.6.

# FIG.7.

FIG.8.

FIG.9.

FIG.10.

# FIG.11.

FIG.12.